# EUROPÄISCHE PATENTSCHRIFT

(11) **EP 2 852 976 B1**
(45) Veröffentlichungstag und Bekanntmachung des Hinweises auf die Patenterteilung: **11.10.2017**
(21) Anmeldenummer: 13713151.2
(22) Anmeldetag: 26.03.2013
(51) Int. Cl.: H01L 27/15, H01L 31/18, H01L 33/00, H01L 31/046, H01L 31/0465, H01L 31/054, H01L 31/0384, H01L 33/62, H01L 31/05

(54) **VERFAHREN FÜR EIN HERSTELLEN VON VERSCHALTETEN OPTOELEKTRONISCHEN BAUTEILEN SOWIE VERSCHALTETE OPTOELEKTRONISCHE BAUTEILE**
METHOD FOR PRODUCING INTERCONNECTED OPTOELECTRONIC COMPONENTS, AND INTERCONNECTED OPTOELECTRONIC COMPONENTS
PROCÉDÉ POUR PRODUIRE DES COMPOSANTS OPTOÉLECTRONIQUES CONNECTÉS ET COMPOSANTS OPTOÉLECTRONIQUES CONNECTÉS

(30) Priorität: 22.05.2012 DE 102012208552
(43) Veröffentlichungstag der Anmeldung: 01.04.2015
(73) Patentinhaber: Crystalsol GmbH, 1110 Wien (AT)
(72) Erfinder: MEISSNER, Dieter, 21514 Büchen (DE)
(74) Vertreter: Gille Hrabal
(86) Internationale Anmeldenummer: PCT/EP2013/056348
(87) Internationale Veröffentlichungsnummer: WO 2013/174548

(56) Entgegenhaltungen:
- EP-A1- 1 521 309
- WO-A1-2005/029657
- WO-A1-2007/085343
- WO-A2-2010/000581
- US-A- 5 674 325

## Beschreibung

Die Erfindung betrifft ein Verfahren für ein Herstellen von vorzugsweise seriell verschalteten optoelektronischen Bauteilen sowie verfahrensgemäß elektrisch verschaltete optoelektronische Bauteile. Optoelektronische Bauteile wandeln Licht in elektrischen Strom oder umgekehrt. Beispiele für optoelektronische Bauteile sind Solarzellen wie Dünnschichtsolarzellen, fotoelektrische Detektoren oder Licht emittierende Dioden.

Dünnschichtsolarzellen, beispielsweise basierend auf amorphem Silizium, bestehen aus einer Reihe von Einzelschichten, nämlich einem Substrat sowie einer hierauf aufgebrachten Rückkontaktschicht, einer aktiven Schicht, inklusive eventueller Pufferschichten oder anderer notwendiger Schichten und einer Frontkontaktschicht. Die Einzelschichten können nach dem Aufbringen der jeweiligen Schicht, sofern dies erforderlich ist, beispielsweise mittels Laser oder mechanisch strukturiert werden, um eine Unterteilung in einzelne Schichten zu erhalten.

Aus der Druckschrift WO 2007/085343 A1 geht ein Verfahren für ein Herstellen von verschalteten Solarzellen hervor, bei dem in einer Abscheidekammer ein Substrat auf eine in Richtung einer Abscheideeinrichtung gewölbte Auflagefläche aufgebracht wird. Das Substrat steht unter mechanischer Vorspannung oder ist entsprechend der Auflagefläche gewölbt. Eine Strukturierung einer aufzubringenden Schicht erfolgt mittels gespannter Drähte, die mit einer definierten Kraft gegen das auf die gewölbte Auflagefläche aufgebrachte Substrat anliegen und die bereits aufgebrachten Materialschichten oder das Substrat abschatten. Durch die Abschattung wird eine nachfolgend aufzubringende Materialschicht strukturiert.

Aus der Druckschrift WO 2010/000581 A1 geht ein Verfahren zur Herstellung einer Monokornmembran hervor, bei dem eine Schicht aus einem Binder bereitgestellt wird. Fotoelektrisch aktive Körner werden durch eine Oberfläche der Schicht hindurch in die Schicht hinein gebracht. Anschließend wird der Binder verfestigt. Werden die Körner zu beiden Seiten der Schicht im Anschluss daran elektrisch kontaktiert, so wird so z. B. eine Solarzelle geschaffen,

Es ist Aufgabe der vorliegenden Erfindung, ein Verfahren bereitzustellen, das eine technisch einfache Fertigung von elektrisch miteinander verbundenen optoelektronischen Bauteilen ermöglicht. Darüber hinaus ist es Aufgabe der Erfindung, elektrisch miteinander verbundene optoelektronische Bauteile bereitzustellen, die auf einfache Weise gefertigt werden können.

Ein Verfahren umfasst zur Lösung der Aufgabe die Merkmale des ersten Anspruchs.

In einem ersten Schritt wird eine Schicht mit zumindest einem darin befindlichen ersten Draht oder Faden geschaffen. Der erste Draht oder Faden ist entweder von Anfang an elektrisch leitfähig oder kann nachträglich so behandelt werden, dass dieser durch die Behandlung elektrisch leitfähig wird. Ein erster und zweiter elektrooptisch aktiver Bereich der Schicht werden mit dem ersten Draht oder Faden elektrisch so verbunden, dass diese vorzugsweise seriell miteinander elektrisch verschaltet sind. Durch den Draht werden Bereiche der Schicht auf einfache Weise unterteilt, wodurch auf technisch einfache Weise eine Mehrzahl von optoelektronischen Bauteilen geschaffen wird. Eine kontinuierliche Produktion ist möglich. Insbesondere können das aus der WO 2010/000581 A1 bekannte Verfahren in angepasster Form durchgeführt werden. Eine Anpassung ist dann und nur dann erforderlich, soweit nachfolgend etwas anderes beschrieben wird. So wird dass aus der WO 2010/000581 A1 bekannte Verfahren derart weiter entwickelt, dass das darin beschriebene elektrisch leitfähige Material, welches bahnen- oder streifenförmig gefertigt wird, durch den ersten Draht oder Faden bereitgestellt wird, der während einer kontinuierlichen Produktion von einer Rolle abgewickelt wird. Soweit nachfolgend nicht anderes beschrieben, werden die in der WO 2010/000581 A1 genannten Materialen vorzugsweise eingesetzt. Wir beziehen den Offenbarungsgehalt der WO 2010/000581 A1 in die vorliegende Anmeldung ein.

In die zum Beispiel 1 bis 100 *µ*m dicke Schicht, die als Membran vorliegen kann, wird in einer Ausführungsform zumindest ein erster Draht oder Faden durch eine Schichtoberfläche hindurch eingebracht und zwar insbesondere derart, dass dieser gegenüber der Schichtoberfläche an wenigstens einer Seite, vorzugsweise gegenüber beiden Schichtoberflächen hervorsteht. Der Draht oder Faden wird dabei insbesondere von einer Rolle abgewickelt, um besonders einfach zu produzieren. Eine Membran wird ebenfalls in einer Ausführungsform von einer Rolle abgewickelt, um kontinuierlich zu produzieren.

Wird der Draht oder Faden durch eine Oberfläche hindurch in die Schicht gebracht, so zum Beispiel hineingedrückt, so wird ein anschließend ein gegenüber dieser Oberfläche vorstehender Drahtbereich nicht durch das Material der Schicht verunreinigt und kann daher vorteilhaft ohne einen Reinigungsschritt elektrisch kontaktiert werden.

Die Schicht kann aus einem optoelektronischen Material, d. h. einem Material, welches Licht in elektrischen Strom umzuwandeln vermag oder umgekehrt, bestehen.

Vorzugsweise wird in einer Ausführungsform optoelektronisches Material in die nicht elektrisch leitfähige Schicht bzw. Membran eingebracht und zwar insbesondere in der aus der WO 2010/000581 A1 bekannten Weise oder aber die Membran enthält bereits optoelektronisches Material, bevor der erste Draht oder Faden in die Schicht bzw. Membran gebracht wird. Es steht so eine Schicht bzw. Membran, beispielsweise die aus der vorgenannten internationalen Patentanmeldung bekannte Monokornmembran bereit, die aufgrund des ersten Drahtes oder Fadens eine durch die Schicht bzw.

Membran hindurch führende elektrische Kontaktierung des eingebrachten optoelektronischen Materials ermöglicht.

Das optoelektronische Material, welches in die Schicht aus elektrisch nicht leitendem Material gebracht wird, liegt vorzugsweise in Form von Partikeln vor. Die Partikel werden von einer Seite durch die Oberfläche der Schicht in einer Ausführungsform der Erfindung in diese eingebracht und zwar insbesondere lediglich teilweise derart, dass diese gegenüber der Oberfläche vorstehen. Vorzugsweise ist der Partikeldurchmesser größer als die Dicke der Schicht. Bei dieser Ausführungsform werden die Partikel insbesondere so eingebracht, dass diese gegenüber beiden Seiten der Schicht vorstehen.

Die Partikeldurchmesser liegen in einer Ausführungsform zum Beispiel zwischen 2 und 110 *µ*m, so zum Beispiel zwischen 63 und 75 *µ*m. Vorteilhaft ist die Größenverteilung klein. Die Partikeldurchmesser variieren bevorzugt um lediglich bis zu 20 *µ*m, bevorzugt um bis zu 15 *µ*m, um möglichst sämtliche Partikel zuverlässig elektrisch zu kontaktieren. Es wird dann das Partikelmaterial zumindest praktisch vollständig genutzt.

Durch den ersten Draht oder Faden wird auf technisch einfache Weise ein elektrischer Leiter bereitgestellt, der einen Rückkontakt eines optoelektronischen Bauteils mit einem Frontkontakt eines angrenzenden optoelektronischen Bauteils zu verbinden vermag. Insbesondere werden Rückkontakt sowie Frontkontakt im Anschluss an das Einbringen des ersten Drahtes und oder Fadens so aufgebracht, dass diese mit dem ersten Draht oder Faden elektrisch leitend verbunden werden. Handelt es sich um einen anfänglich noch nicht elektrisch leitenden Faden, so wird dieser elektrisch leitend gemacht, und zwar in der Regel vor dem Aufbringen des Rückkontakts und/oder Frontkontakts. Ragt der Draht oder Faden nur an einer Seite der Schicht bzw. Membran gegenüber der Oberfläche hervor, so wird die andere Seite zuvor bei Bedarf geeignet freigelegt, zum Beispiel durch Schleifen, um den ersten Draht oder Faden durch den Rückkontakt oder Frontkontakt elektrisch kontaktieren zu können. Der erste Draht kann aus Metall bestehen. Es genügt aber, dass die Oberfläche des ersten Drahtes oder Fadens derart mit einem elektrisch leitfähigen Material beschichtet ist, dass dadurch ein elektrischer Leiter durch die Schicht hindurch bereitgestellt werden kann.

In einer Ausführungsform dient der erste Draht einer Kontaktierung der optoelektronischen Bauteile nur von einer Seite, vorzugsweise nur von der Rückseite aus, um beispielsweise Störungen des Lichteinfalls oder Lichtaustritts auf der Frontseite zu minimieren. Die optoelektronischen Bauteile weisen dann beispielsweise voneinander elektrisch getrennte Rückkontakte auf sowie elektrisch miteinander verbundene Frontkontakte. Darüber hinaus gibt es ein oder mehrere erste Drähte, die die optoelektronischen Bauteile voneinander trennen, die mit den Frontkontakten elektrisch verbunden sind, nicht aber mit den Rückkontakten und die es ermöglichen, von der Rückseite der optoelektronischen Bauteile aus nicht nur die Rückkontakte, sondern auch die Frontkontakte elektrisch zu kontaktieren.

Die Schicht kann sich auf einem zum Beispiel aus Glas bestehenden Substrat oder einer anderen Schicht befinden. Vorteilhaft ist die Schicht sowie ggf, das Substrat nebst eventuell vorhandener weiterer Schichten biegsam, was die Produktion vereinfacht und beschleunigt. Insbesondere kann kontinuierlich gefertigt werden, indem die Schicht nebst Substrat und weiterer Schichten als Bahn bereitgestellt bzw. gefertigt wird. Insbesondere ein Substrat liegt vorteilhaft zwecks rascher Produktion als Endlosbahn vor, die zum Beispiel von einer Rolle abgewickelt wird. Das biegsame Substrat kann z. B. aus Metall oder einem Polymer bestehen und liegt insbesondere als Folie vor.

Um den ersten Draht oder Faden In die Schicht einbringen zu können, ist das Material der Schicht in einer bevorzugten Ausführungsform ein zumindest noch nicht vollständig ausgehärtetes Polymer. Das Material des Polymers verhält sich also flüssig, zähflüssig oder zumindest plastisch, wenn der erste Draht oder Faden in das Polymer zum Beispiel hineingedrückt wird oder aufgrund von Schwerkraft in die Schicht hinein sinkt. Erst im Anschluss an das Einbringen daran wird das Material der Schicht vollständig ausgehärtet. Vorzugsweise ist das Aushärten des Materials der Schicht vor dem Einbringen des ersten Drahtes oder Fadens bereits derart fortgeschritten, dass das Material sich zähflüssig bis plastisch verhält. Hierdurch wird erreicht oder zumindest unterstützt, dass nach dem Einbringen des ersten Drahtes oder Fadens in das zähflüssige bzw, plastische Material der Draht fixiert ist, um seine Lage beizubehalten.

Der Durchmesser des ersten Drahts oder Fadens ist vorzugsweise größer als die Dicke der Schicht bzw. Membran. Diese Ausführungsform ermöglicht ein Vorstehen des Drahtes an beiden Seiten der Schicht bzw. Membran durch Einbringen des ersten Drahtes von einer Seite in die Membran hinein. Die Schicht oder Membran kann sich beispielsweise auf einer plastischen Grundschicht befinden, so zum Beispiel auf einer Klebstoffschicht. Wird der erste Draht oder Faden in die gegenüberliegende Oberfläche der Schicht bzw, Membran zum Beispiel hinein gedrückt, so erreicht der erste Draht oder Faden schließlich die Grundschicht und steht dann gegenüber beiden Oberflächen der Schicht oder Membran hervor und zwar zumindest dann, wenn der erste Draht oder Faden etwas in die plastische Grundschicht hinein gedrückt worden ist. Wird zu einem späteren Zeitpunkt die Grundschicht entfernt, so zum Beispiel abgewaschen, so kann der erste Draht oder Faden von beiden Seiten für ein serielles Verbinden elektrisch kontaktiert werden. Insbesondere kann bei dieser Ausführungsform ein Abtragen von Material wie zum Beispiel Schleifen oder Ätzen vermieden werden, was mit Beschädigungen einhergehen könnte. Auf technisch besonders einfache und schonende Weise kann so ein durchgehender elektrischer Kontakt durch die Schicht bzw, Membran hindurch bereitgestellt werden.

In einer vorteilhaften Ausführungsform der Erfindung ragt zumindest ein erster Draht, vorzugsweise eine Mehrzahl von ersten Drähten derart gegenüber der Frontseite hervor, dass in Richtung Draht eintretendes Licht durch den Draht in zumindest eine angrenzende optoelektronisch aktive Schicht umlenkt wird. Der Wirkungsgrad lässt sich so verbessern. Vorzugsweise ist der Querschnitt des Drahtes oder Fadens so, dass hierdurch die gewünschte Umlenkung möglichst maximiert wird. Dreieckige, fünfeckige oder runde oder ovale Querschnitte sind geeignet, um in gewünschter Weise umlenken zu können. Insbesondere bei dieser Ausführungsform weist der Draht oder Faden eine metallische und damit gut reflektierende Oberfläche auf.

In einer bevorzugten Ausführungsform der Erfindung werden im Anschluss an das Einbringen des ersten Drahts oder Fadens Partikel von einer Seite aus in die Schicht hinein gebracht, so zum Beispiel hineingedrückt, die aus einem optoelektronischen Material bestehen. So wird erreicht, dass das Einbringen des Drahtes in die Schicht nicht durch bereits in der Schicht vorhandene Partikel behindert wird. Produktionsfehler werden so verbessert vermieden.

Vorzugsweise werden die zum Beispiel aus einem Halbleiter bestehenden Partikel durch eine Oberfläche der Schicht eingebracht, gegenüber der ein erster Draht oder Faden hervorsteht. Steht der erste Draht oder Faden gegenüber der Oberseite der Schicht bzw. Membran hervor, so lenkt der Draht oder Faden optoelektronische Partikel vorteilhaft in Bereiche der Membran hinein, in denen die optoelektronischen Partikel wirksam werden können. Es wird so besonders zuverlässig vermieden, dass Partikel eine spätere elektrische Kontaktierung des ersten Drahtes oder des erforderlichenfalls leitfähig gemachten Fadens behindern.

Ist ein erster Draht in die Schicht gebracht worden, so können optoelektronisch aktive Bereiche der Schicht in einer Ausführungsform im Anschluss daran in der aus der WO 2010/000581 A1 bekannten Weise seriell miteinander verschaltet werden. Optoelektronisch aktive Bereiche können aber auch in einer anderen Ausführungsform der Erfindung in der für kristalline Solarzellen bevorzugten Weise gemeinsam eine durchgehende Solarzelle bilden. Die eingebetteten Kontakte erlauben dann in einer weiteren Anwendung eine Ableitung des Frontkontaktes über die Rückseite, wie dies in sogenannten "wrap-through" Kontaktierungen genutzt wird.

In einer weiteren bevorzugten Ausführungsform werden durch die eingebetteten, ein oder mehreren ersten Drähte oder Fäden angrenzende Elektroden an lichtemittierende Halbleiter- oder Halbleiterpulver-Schichten kontaktiert. Dies erlaubt wegen der guten Leitfähigkeit der eingebetteten, ein oder mehreren ersten Drähte oder Fäden eine Stromzuführung (im Falle der Solarzellen eine Stromabführung) ohne nennenswerte Potentialverluste, was für beide Anwendungen von Vorteil ist. Insbesondere bei einer Anwendung in lichtemittierenden Bauelementen erlaubt dies die Sicherstellung einer sehr gleichmäßigen Spannungsversorgung, die besonders in Anwendungen zur großflächigen Lichterzeugung eine sehr homogene und damit vorteilhafte Gleichmäßigkeit sicherstellt.

In einer Ausführungsform der Erfindung wird zum Beispiel für ein serielles Verbinden von zumindest zwei optoelektronischen Bauteilen zumindest ein zweiter Draht oder Faden vorgesehen, der geeignet auf eine entsprechende Oberfläche der Schicht bzw. Membran aufgebracht wird, um Rückkontakte bzw. Frontkontakte für ein serielles Verbinden von optoelektronischen Bauelementen zu strukturieren. Wird anschließend Material auf der Oberfläche mit dem zweiten Draht für das Herstellen von elektrischen Kontakten abgeschieden, so wirkt ein jeder zweiter Draht als Maske, die eine Strukturierung ermöglicht. In einer Ausführungsform bewirkt ein zweiter Draht, dass zwei nebeneinander liegende optoelektronische Bauteile nicht unmittelbar durch zum Beispiel Rückkontakte elektrisch miteinander verbunden werden und insoweit elektrisch voneinander getrennt sind und bleiben.

Ein oder mehrere zweite Drähte oder Fäden werden in einer anderen Ausführungsform dazu genutzt, um Rückkontakte so aufzutragen, dass diese von den ein oder mehreren ersten Drähten elektrisch getrennt sind. Insbesondere bei dieser Ausführungsform wird auf der Frontseite der aktiven Schichten Elektrodenmaterial und zwar insbesondere transparentes Elektrodenmaterial ohne das Vorsehen von zweiten Drähten abgeschieden, so dass das abgeschiedene Elektrodenmaterial sämtliche aktiven Schichten mit den ein oder mehreren ersten Drähten elektrisch miteinander verbindet.

Vorzugsweise grenzt der zumindest eine aufgebrachte zweite Draht an den zumindest einen ersten Draht oder Faden an. Die Strukturierung erfolgt dann in optimaler Weise relativ zum ersten Draht oder Faden. Auf diese Weise kann einerseits das aktive, also optoelektronische Material optimal im späteren Bauteil genutzt werden. Andererseits dient der erste Draht der genauen Justierung der Lage des zweiten Drahtes relativ zum ersten Draht, was das Verfahren deutlich vereinfacht.

Ist der zweite Draht oder Faden auf die Oberfläche der Schicht bzw, Membran aufgebracht worden, so wird im Anschluss daran Material für einen Rückkontakt oder Frontkontakt aufgetragen. Im Anschluss daran wird der zweite Draht oder Faden in einer Ausführungsform entfernt und zwar zumindest dann, wenn der zweite Draht oder Faden elektrisch leitfähig ist. Es wird so die gewünschte Strukturierung geschaffen.

In einer Ausführungsform der Erfindung wird jeweils ein zweiter Draht oder Faden angrenzend an beide Seiten eines ersten Drahtes aufgebracht. Im Anschluss daran wird Material für einen Kontakt, vorzugsweise für einen Rückkontakt aufgebracht. Die beiden zweiten Drähte bewirken, dass die aufgebrachten Kontakte, insbesondere Rückkontakte im Endprodukt von dem ersten Draht elektrisch getrennt sind.

Vorteilhaft ist der zweite Draht oder Faden elektrisch nicht leitend. Es kann dann vorteilhaft ein Herstellungsschritt vermieden werden, nämlich der Schritt des Entfernens des zweiten Drahtes im Anschluss an das Auftragen des Materials für Rückkontakte oder Frontkontakte, da der zweite Draht dann elektrisch leitfähige Bereiche elektrisch voneinander trennt.

Um besonders zuverlässig zu vermeiden, dass Material des Rückkontakts oder Frontkontakts während des Auftragens zwischen die Oberfläche der Schicht bzw. Membran und dem zweiten Draht gelangen kann, liegt der zweite Draht in einer Ausführungsform mit Druck auf der Oberfläche der Membran auf. Vorzugsweise wird dieser Druck erzeugt, indem die Membran gewölbt bereitgestellt wird und der Draht im gespannten Zustand sich über die Wölbung hinweg erstreckt, also in der aus der Druckschrift WO 2007/085343 A1 bekannten Weise vorgegangen wird.

Der zweite Draht oder Faden, der zum Beispiel aus Metall oder einem Polymer bestehen kann, weist vorzugsweise einen geringen thermischen Ausdehnungskoeffizienten auf und/ oder Dehnungskoeffizienten auf. Der thermische Ausdehnungskoeffizient und/ oder Dehnungskoeffizient ist vorzugsweise geringer als Ausdehnungskoeffizient bzw. Dehnungskoeffizient des ersten Drahts. Die Beibehaltung der Lage des zweiten Drahtes auf der Oberfläche der Schicht lässt sich dann verbessert sicherstellen.

Die Dicke der Kontakte ist grundsätzlich geringer als der Durchmesser des zweiten Drahtes. Vorzugsweise ist der Durchmesser des zweiten Drahts oder Fadens wenigstens doppelt so dick wie die Dicke eines Front- oder Rückkontakts, um Front- bzw. Rückkontakte zuverlässig elektrisch voneinander zu trennen.

Der Abstand zwischen zweitem und erstem Draht ist vorzugsweise kleiner als 1 mm, um zu guten Wirkungsgraden zu gelangen.

Sind die optoelektronischen bzw. optoelektronisch aktiven Bereiche miteinander seriell verbunden worden, so wird das System in der Regel in bekannter Weise gekapselt, um die Bauteile vor äußeren Einflüssen wie Feuchtigkeit zu schützen. Insbesondere werden so miteinander seriell elektrisch verbundene Solarzellen geschaffen.

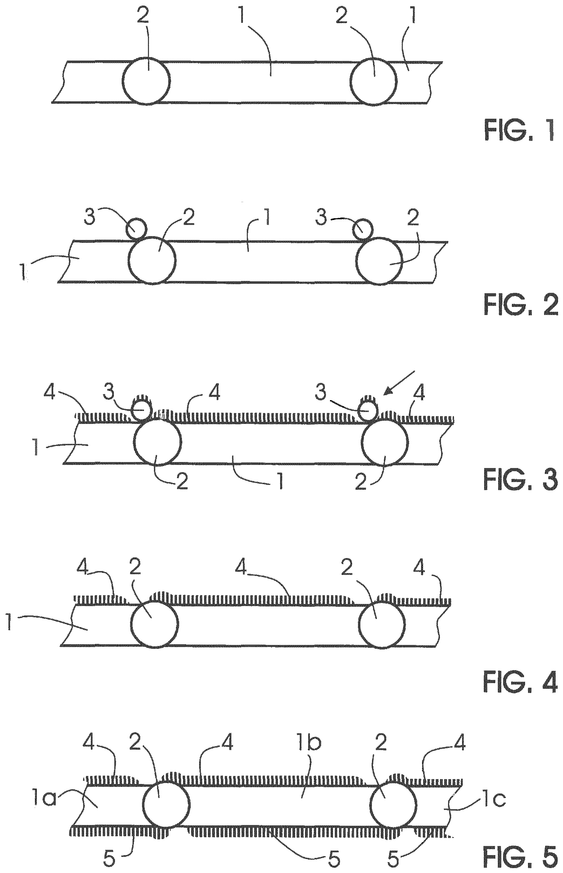

Die Figur 1 zeigt in einer Schnittdarstellung eine Schicht 1, die vorzugsweise aus einem nicht vollständig ausgehärteten Polymermaterial besteht. In die Schicht 1 sind in regelmäßigen Abständen vorzugsweise aus Metall bestehende erste Drähte 2 hinein gedrückt worden und zwar derart, dass die ersten Drähte 2 schließlich gegenüber beiden Oberflächen der Schicht 1 hervorstehen.

Im Anschluss an diesen ersten Herstellungsschritt werden wie in der Figur 2 gezeigt zweite Drähte 3 auf die Oberfläche der Schicht 1 aufgelegt und zwar jeweils angrenzend an die ersten Drähte 2. Die Durchmesser der zweiten Drähte 3 sind vorteilhaft sehr klein und zwar insbesondere sogar kleiner als die Durchmesser der Drähte 1, um so optoelektronisches Material in bestmöglicher Weise nutzen zu können.

Im Anschluss an das Aufbringen der zweiten Drähte 3 wird Elektrodenmaterial wie zum Beispiel ITO auf der Oberfläche wie in der Figur 3 gezeigt abgeschieden. Es kann senkrecht zur Oberfläche abgeschieden werden. Vorteilhaft wird aber in einer Ausführungsform unter einem Winkel kleiner als 90 Grad wie in der Figur 3 durch den Pfeil angedeutet von rechts oben nach links unten abgeschieden, wenn sich der zweite Draht links vom ersten Draht befindet (oder entsprechend umgekehrt) und zwar vor allem dann, wenn der zweite Draht oder Faden 3 aus einem nicht elektrisch leitenden Material besteht. Diese Abscheiderichtung unterstützt, dass im Anschluss an das Abscheiden ein zweiter Draht oder Faden 3 nicht mehr entfernt werden muss, um die elektrischen Kontakte geeignet voneinander elektrisch zu trennen.

In der Figur 4 wird der Fall dargestellt, dass die zweiten Drähte oder Fäden 3 entfernt wurden. Im Anschluss daran kann in gleicher Weise die andere Seite mit Kontakten versehen werden, so dass schließlich der in der Figur 5 gezeigte Gegenstand vorliegt. Dieser umfasst drei optoelektronische Bauteile mit jeweils einer optoelektronisch aktiven Schicht 1a, 1b, 1c, mit jeweils einem elektrisch leitenden Frontkontakt 4, einem elektrische leitenden Rückkontakt 5, die so die ersten Drähte 2 elektrisch kontaktieren bzw. nicht kontaktieren, dass die drei optoelektronischen Bauteile mit den aktiven Bereichen 1a, 1b und 1c elektrisch seriell miteinander verbunden sind.

In der Figur 5 ist ein System von optoelektronischen Bauteilen jeweils umfassend einen optoelektronisch aktiven Bereich 1a, 1b, 1c dargestellt. Erste Drähte oder Fäden 2 unterteilen optoelektronisch aktive Bereiche 1a, 1b, 1c der Schicht 1. Die ersten Drähte oder Fäden 2 verbinden optoelektronische aktive Bereiche 1a, 1b, 1c mittels Rückkontakte 5 und Frontkontakte 4 seriell. Insbesondere die Frontkontakte bestehen aus einem transparenten Material, um Licht von außen in die optoelektronisch aktiven Bereiche 1a, 1b, 1c hinein gelangen zu lassen oder umgekehrt.

Handelt es sich bei dem Material der Schicht 1 nicht um ein optoelektronisches Material, dann wird in diese Schicht 1 optoelektronisches Material hinzugefügt und zwar vorzugsweise in Form von Partikeln. Die Partikel werden insbesondere dann eingebracht, wenn der in der Figur 1 gezeigte Zustand vorliegt und das Material der Schicht 1 noch fleißfähig ist, also insbesondere vor einem vollständigen Aushärten eines Polymermaterials. Die Partikeldurchmesser sind bevorzugt etwas größer als die Dicke der Schicht 1, damit diese in gleicher Weise gegenüber beiden Oberflächen zwecks Kontaktierung hervorstehen können wie der erste Draht der Faden 2.

## Patentansprüche

1. Verfahren für ein Herstellen von elektrisch verschalteten optoelektronischen Bauteilen, bei dem eine optoelektronisch aktive Schicht (1) mit zumindest einem elektrisch leitfähigen Bereich bereitgestellt wird, der als erster Draht oder Faden (2) vorliegt und der zwei optoelektronische Bereiche der optoelektronischen Schicht voneinander trennt, **dadurch gekennzeichnet, dass** für ein elektrisches Verbinden von zumindest zwei optoelektronischen Bereichen der optoelektronischen Schicht zumindest ein zweiter Draht oder Faden (3) vorgesehen ist, der geeignet auf eine entsprechende Oberfläche der optoelektronischen Schicht aufgebracht wird, um durch Abscheidung geschaffene Rückkontakte bzw. Frontkontakte für ein elektrisches Verbinden von optoelektronischen Bereichen zu strukturieren, wobei für den zumindest einen zweiten Draht oder Faden (3) eine Anlage bereitgestellt ist, wobei die Anlage ein gegenüber der Oberfläche vorstehender Bereich des ersten Drahts oder Fadens (2) ist.

2. Verfahren nach Anspruch 1, **dadurch gekennzeichnet, dass** die optoelektronische Schicht (1) mit zumindest einem darin befindlichen ersten Draht oder Faden (2) geschaffen wird, der elektrisch leitfähig ist oder elektrisch leitfähig gemacht wird, und ein erster und zweiter optoelektronisch aktiver Bereich (1a, 1b, 1c) der optoelektronischen Schicht (1) mit dem zumindest einen ersten Draht (2) elektrisch so verbunden wird, dass die beiden optoelektronisch aktiven Bereiche (1a, 1b, 1c) elektrisch miteinander verbunden sind.

3. Verfahren nach Anspruch 2, **dadurch gekennzeichnet, dass** der erste Draht oder Faden (2) durch eine Oberfläche der optoelektronischen Schicht (1) so hineingebracht wird, dass der erste Draht oder Faden (2) teilweise gegenüber der Oberfläche der optoelektronischen Schicht vorsteht.

4. Verfahren nach einem der vorgehenden Ansprüche, **dadurch gekennzeichnet, dass** in die optoelektronische Schicht, die insbesondere aus einem elektrisch nicht leitenden Material besteht, Partikel eingebracht werden oder sind, die aus einem optoelektronischen Material bestehen und zwar insbesondere im Anschluss an das Einbringen von zumindest einem ersten Draht oder Faden (2).

5. Verfahren nach einem der vorhergehenden Ansprüche, **dadurch gekennzeichnet, dass** die optoelektronische Schicht biegsam ist und/ oder auf oder oberhalb eines biegsamen Substrats aufgebracht ist.

6. Verfahren nach dem vorhergehenden Anspruch, **dadurch gekennzeichnet, dass** der erste Draht oder Faden (2) in die optoelektronische Schicht hingedrückt wird, wenn das Material der optoelektronischen Schicht als nur teilweise ausgehärtetes Polymer vorliegt.

7. Verfahren nach einem der vorhergehenden Ansprüche, **dadurch gekennzeichnet, dass** der zweiter Draht (3) an dem gegenüber der Schichtoberfläche vorstehenden ersten Draht angelegt wird und im Anschluss daran elektrisches Kontaktmaterial auf der optoelektronischen Schicht (1) abgeschieden wird.

8. Verfahren nach einem der vorhergehenden Ansprüche, **dadurch gekennzeichnet, dass** der zumindest eine zweite Draht oder Faden (3) im Anschluss an ein Aufbringen von elektrischem leitfähigem Material für die Herstellung eines Rück- oder Frontkontaktes entfernt wird.

9. System von optoelektronischen Bauteilen, insbesondere Solarzellen, jeweils umfassend eine optoelektronische Schicht (1), herstellbar nach einem Verfahren nach einem der vorhergehenden Ansprüche, mit einem ersten elektrisch leitfähigen Draht oder Faden (2), der die optoelektronische Schicht (1) in optoelektronisch aktive Bereiche (1a, 1b, 1c) unterteilt, sowie elektrisch mittels Rückkontakt (5) und Frontkontakt (4) seriell verbindet, **dadurch gekennzeichnet, dass** zumindest ein erster Draht oder Faden (2) mit vorzugsweise metallischer Oberfläche gegenüber optoelektronisch aktiven Bereichen derart hervorsteht und beschaffen ist, dass dieser auf den Draht oder Faden (2) einfallendes Licht in Richtung optoelektronisch aktive Bereiche umzulenken vermag.

## Claims

1. Method for producing interconnected optoelectronic components, wherein an optoelectronic active layer (1) is provided with at least one electrically conductive area, which is provided as a first wire or thread (2) and which separates two optoelectronic areas of the optoelectronic layer from each other, **characterized in that** for the purpose of electrically connecting at least two optoelectronic areas of the optoelectronic layer, at least a second wire or thread (3) is provided, which is appropriately applied on a corresponding surface of the optoelectronic layer in order to structure back contacts or front contacts that were created by deposition for electrically contacting optoelectronic areas, wherein a stop is provided at least for the one second wire or thread (3), wherein the stop is an over the surface protruding area of the first wire or thread (2).

2. Method according to claim 1, **characterized in that** the optoelectronic layer (1) is created with at least one therein arranged first wire or thread (2), which is electrically conductive or is made electrically conductive, and a first and second optoelectronic active area (1a, 1b, 1c) of the optoelectronic layer (1) is electrically connected to the at least one first wire (2) in such a way that both optoelectronic active areas (1a, 1b, 1c) are electrically connected with each other.

3. Method according to claim 2, **characterized in that** the first wire or thread (2) is applied though a surface of the optoelectronic layer (1) in such a way that the first wire or thread (2) partially protrudes over the surface of the optoelectronic layer.

4. Method according to one of the preceding claims, **characterized in that** particles are added or being added in the optoelectronic layer, which in particular is formed of an electrically not conductive material and specifically in particular subsequently to the applying of at least one first wire or thread (2).

5. Method according to one of the preceding claims, **characterized in that** the optoelectronic layer is flexible and/or applied on or above a flexible substrate.

6. Method according to the preceding claim, **characterized in that** the first wire or thread (2) is pushed through the optoelectronic layer when the material of the optoelectronic layer is provided as an only partly cured polymer.

7. Method according to one of the preceding claim, **characterized in that** the second wire (3) is abutted against the first wire, which protrudes over the layer surface, and subsequent to that, electric contact material is deposited on the optoelectronic layer (1).

8. Method according to one of the preceding claims, **characterized in that** the at least one second wire or thread (3) is removed subsequent to applying electrically conductive material for the production of back or front contacts.

9. System of optoelectronic components, in particular solar cells, each comprising an optoelectronic layer (1), producible by a method of one of the preceding claims, comprising a first electrically conducting wire or thread (2), which separates the optoelectronic layer (1) into optoelectronic active areas (1a, 1b, 1c), as well as electrically connects them serially by means of back contact (5) and front contact (4), **characterized in that** at least one first wire or thread (2) protrudes over optoelectronic active areas with preferably a metallic surface and is composed in such a way that it allows redirecting light, which falls on the wire or thread, in direction of optoelectronic active areas.

## Revendications

1. Procédé de fabrication de composants optoélectroniques électriquement raccordés, dans lequel une couche (1) optoélectroniquement active ayant au moins une région électriquement conductrice est fournie, qui est présente en tant que premier fil de fer ou fil (2) et qui, en tant que premier fil de fer ou fil (2), sépare deux régions optoélectroniques l'une de l'autre, **caractérisé en ce que** pour un raccordement électrique d'au moins deux régions optoélectroniques de la couche optoélectronique au moins un second fil de fer ou fil (3) est prévu, qui est appliqué convenablement sur une surface appropriée de la couche optoélectronique pour structurer des contacts arrières et des contacts avants générés par déposition pour un raccordement électrique de régions optoélectroniques, dans lequel pour ledit au moins l'un de second fil de fer ou fil (3) une butée est fournie, dans lequel la butée est une région en saillie du premier fil de fer ou fil (2) à l'égard de la surface.

2. Procédé selon la revendication 1, **caractérisé en ce que** la couche optoélectronique (1) est réalisée ayant dedans au moins un premier fil de fer ou fil (2) qui est fait électriquement conducteur, et une première et seconde région (1a, 1b, 1c) optoélectroniquement active de la couche (1) optoélectronique ayant ledit au moins un premier fil de fer (2) est raccordée électriquement de telle façon que les deux régions optoélectroniquement actives (1 a, 1b, 1c) sont électriquement raccordées l'une avec l'autre.

3. Procédé selon la revendication 2, **caractérisé en ce que** le premier fil de fer ou fil (2) est inséré à travers une surface de la couche (1) optoélectronique de telle façon que le premier fil de fer ou fil (2) est en saillie à l'égard de la surface de la couche optoélectronique.

4. Procédé selon l'une des revendications précédentes, **caractérisé en ce que** dans la couche optoélectronique, qui est constituée en particulier d'un matériau électriquement non conducteur, des particules sont introduites ou sont en train d'être introduites, qui sont constituées d'un matériau optoélectronique, et ceci suite à l'introduction d'au moins un premier fil de fer ou fil (2).

5. Procédé selon l'une des revendications précédentes, **caractérisé en ce que** la couche optoélectronique est flexible et/ou est appliquée au-dessus d'un substrat flexible.

6. Procédé selon la revendication précédente, **caractérisé en ce que** le premier fil de fer ou fil (2) est poussé dans la couche optoélectronique lorsque le matériau de la couche optoélectronique est présent en tant que polymère partiellement durci.

7. Procédé selon l'une des revendications précédentes, **caractérisé en ce que** le second fil (3) est appuyé contre le premier fil en saillie à l'égard de la surface et par la suite du matériau de contact électrique est déposé sur la couche optoélectronique (1).

8. Procédé selon l'une des revendications précédentes, **caractérisé en ce que** ledit au moins un deuxième fil de fer ou fil (3), est enlevé, suite à l'application de matériau électriquement conducteur, pour la fabrication d'un contact arrière ou d'un contact avant.

9. System de composants optoélectroniques, notamment des cellules solaires, chacune comprenant une couche optoélectronique apte à être fabriquée selon un procédé selon l'une des revendications précédentes, ayant un premier fil de fer ou fil électriquement conducteur (2), qui divise la couche optoélectronique (1) en des régions optoélectroniquement actives (1 a, 1b, 1c), ainsi que les raccorde en série moyennant de contact arrière (5) ou contact avant, **caractérisé en ce que** au moins un premier fil de fer ou fil (2) préférentiellement avec surface métallique est en saillie des régions optoélectroniquement actives et est agencé de telle façon que celui-ci est capable de dévier la lumière incident sur le fil de fer ou fil (2) vers des régions optoélectroniquement actives.
